Europäisches Patentamt

European Patent Office

Office européen des brevets

(19)

(11) EP 0 845 785 A1

(12) **DEMANDE DE BREVET EUROPEEN**

(43) Date de publication:
03.06.1998 Bulletin 1998/23

(51) Int Cl.6: **G11C 16/04**, G11C 16/06

(21) Numéro de dépôt: 97402870.6

(22) Date de dépôt: 28.11.1997

(84) Etats contractants désignés:
AT BE CH DE DK ES FI FR GB GR IE IT LI LU MC
NL PT SE
Etats d'extension désignés:
AL LT LV MK RO SI

(30) Priorité: 29.11.1996 FR 9614715

(71) Demandeur: SGS-THOMSON
MICROELECTRONICS S.A.
94250 Gentilly (FR)

(72) Inventeur: Tailliet, François Pierre
75116 Paris (FR)

(74) Mandataire: Ballot, Paul Denis Jacques
Cabinet Ballot-Schmit,
7, rue Le Sueur
75116 Paris (FR)

(54) **Mémoire électronique non volatile et son procédé de gestion**

(57) Pour augmenter la densité d'intégration d'une mémoire de type EEPROM on choisit de se passer de transistor de sélection. Pour aboutir alors à une sélection en effacement en programmation ou en lecture on choisit d'appliquer sur certaines connexions (r' différent de r) de la mémoire des tensions négatives ou de valeur moitié d'une tension de programmation (VPP).

| NŒUDS / OPERATIONS | SW | BL | r | r'≠r |
|---|---|---|---|---|
| EFFACEMENT | Vcc | 0 | Vpp | 0 |
| PROGRAMMATION | 0 | Vpp / Flottant | 0 | Vpp/2 |
| LECTURE | Vcc | TENSION LUE | CGREF | −2 VN |

FIG_4

EP 0 845 785 A1

## Description

L'invention concerne les mémoires électroniques non volatiles pouvant être écrites et effacées électriquement. Elle concerne aussi leur procédé de gestion. Ces mémoires sont dites EEPROM dans la littérature anglo-saxonne. Elles sont essentiellement des mémoires dont les cellules mémoires comportent chacune au moins un transistor à grille flottante en technologie MOS. Le but de l'invention est de créer une structure mémoire de type EEPROM plus compacte que les réalisations actuelles, par la suppression d'un transistor de sélection utilisé dans les cellules mémoires du type EEPROM classique. De ce fait, il devient possible avec l'invention d'obtenir un gain en surface avoisinant 50%. Ceci permet alors d'obtenir des plans mémoires dont la densité avoisine celle de structures de type FLASH, tout en conservant les avantages que présentent les structures de type EEPROM par rapport aux structures de type FLASH.

On rappelle que les mémoires EPROM à grille flottante sont programmable électriquement et non effaçables (ou effaçables par rayons ultraviolets ce qui n'est pas un effacement électrique). Le phénomène électrique de programmation de ces mémoires EPROM est un phénomène d'agitation thermique dans le canal de conduction sous l'effet d'une saturation en courant. Ce phénomène n'est pas réversible. Les mémoires dites EEPROM sont programmables et effaçables électriquement. Le phénomène, réversible, de programmation et d'effacement est un effet tunnel. Par opposition au phénomène de saturation en courant, dit aussi par porteurs chauds, le phénomène tunnel présente l'avantage de ne pas consommer de courant. Les hautes tensions de programmation et l'effacement peuvent alors être produites par des circuits internes à la mémoire (pompes de charges, multiplicateurs). Les mémoires dites FLASH sont hybrides: elles sont programmables par porteurs chauds et effacées par effet tunnel. En pratique, les tensions appliquées sur les grilles, drains et sources des transistors à grille flottante des cellules mémoires renseignent sur le type de programmation et d'effacement provoqué.

Les avantages des cellules mémoires de l'invention par rapport aux cellules FLASH seront essentiellement les suivants:

- une meilleure endurance, car l'effacement et l'écriture ne mettent en oeuvre que l'effet tunnel, tandis que les mémoires FLASH mettent en jeu tour à tour l'effet tunnel et les courants d'électrons chauds;
- un fonctionnement en basse tension d'alimentation, car le courant tunnel est bien moins important que le courant de porteurs chauds, ce qui simplifie grandement la génération de hautes tensions nécessaires aux mécanismes de programmation à l'intérieur même du circuit intégré. Ceci les rend utilisables notamment dans les applications portables, alimentées par piles ou batterie, à des tensions de l'ordre de 2 ou 3 Volts.

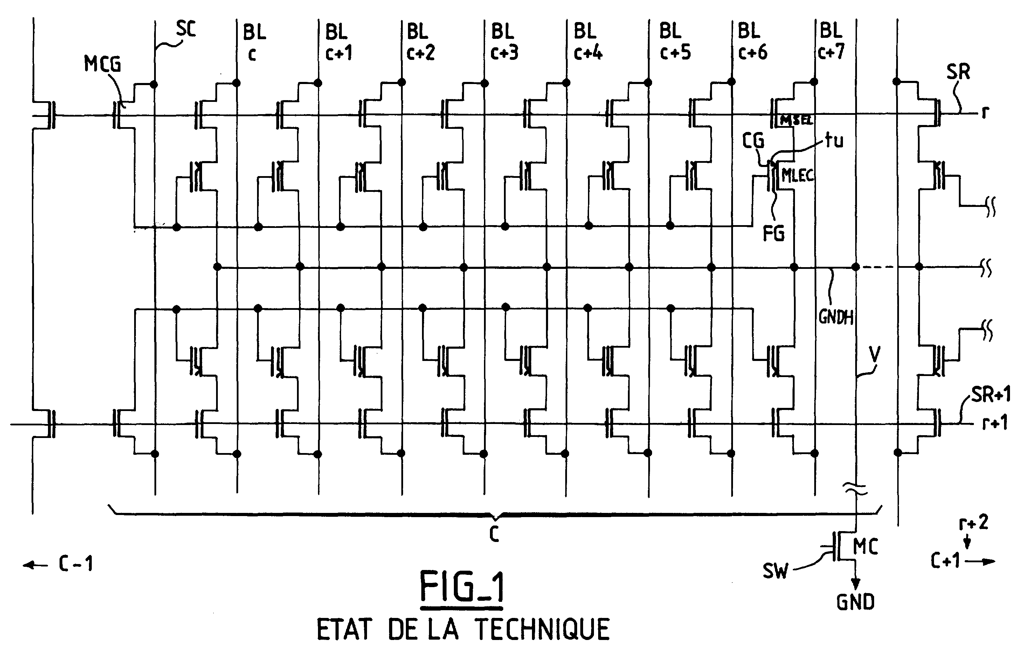

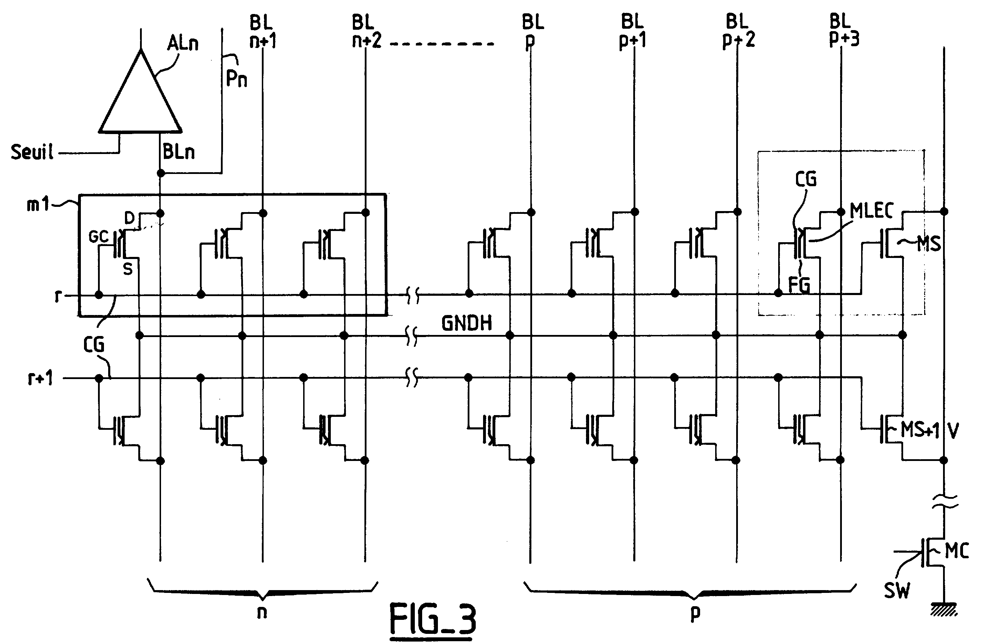

La figure 1 permet de décrire la structure d'un plan mémoire de type EEPROM de l'état de la technique.

Le plan mémoire représenté est adressé de façon matricielle, par des lignes SR, SR+1 de sélection de rangée dite lignes de mot, et des lignes SC d'alimentation de grilles de commande des transistors à grille flottante des cellules d'une colonne. Dans une colonne les cellules sont rassemblées en un mot de 8, 16, 32 ... bits selon les cas. On a représenté une colonne d'indice c et des rangées d'indices r et r+1 dans cette colonne. La figure 1 représente deux octets, huit lignes de bits BLc à BLc+7 étant attachées à la colonne c. On voit que les deux octets sont représentés de façon symétrique par rapport à une ligne horizontale de masse commutée appelée GNDH. La ligne GNDH est reliée à la masse GND du circuit par connexion à une ligne de masse V en série avec un transistor de commutation MC dont la grille est notée SW. A chaque colonne sont donc associées huit lignes de bit, une ligne SC, et une ligne V de connexion à la masse. Les circuits de lecture sont raccordés aux lignes de bit des cellules d'un mot au moment de la lecture.

Une cellule élémentaire, entourée sur la figure 1 est constituée d'un transistor de sélection Msel, et d'un transistor à grille flottante Mlec pour la mémorisation et la lecture. Le transistor Msel permet de relier conditionnellement une ligne de bit, BLc+7 ici, au drain du transistor Mlec. Le transistor Mlec comporte deux grilles empilées: une grille inférieure flottante FG, et une grille supérieure de commande CG. Ces deux grilles sont séparées l'une de l'autre par un oxyde de grille analogue ou d'épaisseur différente de celui qui sépare la grille FG du canal du transistor Msel. Les grilles de commande CG des transistors d'un même octet sont toutes reliées ensemble, et connectées à la ligne SC par un transistor MCG de sélection de grille de commande.

Le transistor Mlec comporte une fenêtre tunnel tu, d'une épaisseur de l'ordre de 80 nm, intercalée entre sa grille flottante et son drain. Dans un exemple, pour une cellule EEPROM, l'épaisseur de cette fenêtre tunnel est de 80 nm, alors qu'elle est de 120 nm pour une cellule EPROM FLASH. L'oxyde de grille est de 200 nm pour une cellule EPROM. La fenêtre tu a pour rôle de laisser passer un courant tunnel (très faible) entre le drain et la grille flottante du transistor Mlec, dès que la tension entre les faces de l'oxyde tunnel dépasse un seuil critique de l'ordre d'une douzaine de Volts, en fait dès que le champ électrique dépasse $15.10^6$ V/m. Selon que cette tension est positive ou négative, la grille flottante se chargera négativement ou positivement. Il apparaît en conséquence une différence de potentiel permanente aux bornes d'un condensateur formé par l'empilement des grilles CG et FG.

La tension de seuil Vt d'un transistor MOS est la tension entre la grille de commande et la source de ce transistor à partir de laquelle le transistor se met à conduire. En notant Vt la tension de seuil intrinsèque du transistor Msel, la conduction de ce transistor Msel est liée à la différence V(FG)-Vt où V(FG) est une tension de grille flottante due à l'accumulation de charges électriques sur cette grille flottante. En appliquant de plus une tension de lecture sur la grille CG, cette différence V(FG) -Vt permet ou ne permet pas de rendre conducteur le transistor Msel. Il en résulte que la conduction du transistor Mlec dépend de la charge du condensateur CG/FG.

Quand les transistors MC et Msel sont passants, le courant entre une ligne de bit BLi et la ligne de masse V dépend de l'état de programmation de la cellule. En appliquant une tension de lecture CGref judicieuse sur les grilles CG, et en comparant un courant passant entre chaque ligne de bit BL et la ligne V, à une valeur de référence, on peut détecter à distance l'état de charge de la grille flottante. Le résultat de la comparaison est transformé en information binaire.

Typiquement, on dit que si le courant est inférieur au courant de référence, la cellule est effacée, et correspond au stockage d'un 0 binaire. Dans une technologie CMOS à substrat P, les cellules effacées correspondent à des transistors avec des électrons stockés sur la grille flottante. Dans le cas inverse, le cellule est dite programmée, et correspond au stockage d'un 1 binaire (avec des trous sur la grille flottante). En lecture, les lignes de bit des octets des différentes colonnes sont multiplexées et reliées à des amplificateurs de lecture, qui sont en gros des comparateurs de courant. On ne détaillera pas cette partie. Elle est la même dans l'invention que dans l'état de la technique.

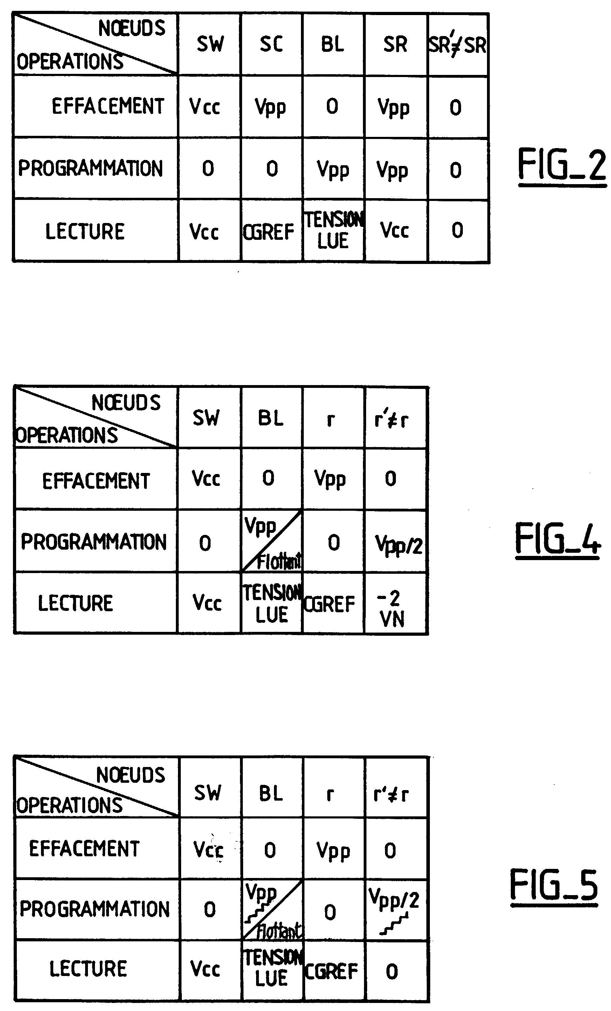

Les conditions de polarisation des différents noeuds de commande des cellules de la figure 1 sont résumées en figure 2. Dans cette figure les noeuds SW, SC, BL, SR et SR' différent de SR sont ceux évoqués jusqu'ici. Les opérations sont celles classiques de gestion des mémoires. Dans les cases du tableau apparaissent les tensions à appliquer sur les noeuds pour obtenir l'exécution de l'opération. Les opérations d'écriture peuvent comporter des opérations d'effacement seules, éventuellement de programmations seules ou des opérations d'effacement suivies de programmation. La tension Vcc vaut de l'ordre de 5 volts, la tension VPP vaut de l'ordre de 12 Volts.

La programmation d'un mot se fait classiquement en deux phases:

- une phase d'effacement de toutes les cellules de ce mot (on injecte des charges (négatives pour un substrat P) dans toutes les grilles flottantes du mot);
- une phase de programmation (enlèvement des charges négatives et injections de charges positives pour un substrat P) sélective des cellules devant être programmées.

On supposera que ce processus est aussi appliqué dans le cadre de l'invention et de ses variantes.

L'opération de programmation est la plus critique. La ligne de masse commutée V est flottante en programmation (SW porté à 0) pour éviter un passage direct de courant entre les lignes de bit BLi portée à VPP et la masse GND, lorsque la grille flottante FG se charge positivement. En effet, dans ce cas le transistor Mlec pourrait se mettre à conduire dès que sa grille flottante deviendrait positive. Du fait de l'architecture adoptée, il apparaît que ni la grille de commande, ni la source du transistor Msel (noeud commun avec le drain du transistor Mlec) d'une cellule d'un octet non sélectionné pour la programmation ou l'effacement ne sont soumis à la haute tension:

- Si la cellule ne fait pas partie de la même rangée (r) que la cellule à programmer, les transistors de sélection Msel et MCG sont bloqués: portés à 0 dans les deux cas. Si la cellule ne fait pas partie de la même colonne que la cellule à programmer, les lignes V et BLi sont déconnectées de la haute tension (par un circuit multiplexeur qui n'est pas décrit ici).

Il en résulte que la programmation d'une cellule n'a aucun effet sur les autres cellules du plan mémoire qu'on ne veut pas programmer.

Une variante de réalisation peut permettre de réduire la surface du plan mémoire, en regroupant les cellules non pas en n octets dans une même rangée, mais en un mot unique, pour toute la rangée, de 8 x n cellules. On parle de page dans ce cas là. L'avantage de cette variante réside dans le gain de place dû à la suppression de (n-1) lignes SC, associées à leurs transistors de sélection MCG. Le gain en encombrement peut atteindre 20%. L'inconvénient en est la perte de la programmation individuelle au niveau de l'octet. La programmation ne se fait ensuite que page par page. Ce type de structure se prête bien aux mémoires de capacité importante, et dans lesquelles les données sont renouvelées par blocs. Cette variante est schématiquement semblable à la figure 1, sauf qu'il n'y a plus un transistor de sélection de grille de commande MCG toutes les huit cellules, mais un pour une page complète (ou pour une proportion moindre mais pour plus que huit cellules). Cette variante est classiquement appelée PEROM (P comme page), la réalisation classique étant appelée EEPROM.

L'invention a pour objet de réduire encore la surface élémentaire d'une cellule dans le but d'augmenter la densité d'intégration. Elle portera sur la suppression des transistors de sélection de cellule. Elle s'applique à la réalisation classique EEPROM ou à la variante PEROM. Elle va être décrite dans le cadre de la première réalisation. Selon l'invention, les problèmes liés à la suppression du transistor de sélection sont résolus en choisissant un mode particulier d'application de tensions sur les noeuds de la cellule.

L'invention a donc pour objet un procédé de gestion, dans un circuit intégré, de cellules mémoires électriquement effaçables et électriquement programmables, comportant chacune un transistor à grille flottante, caractérisé en ce qu'il comporte les opérations suivantes:

- pour une première cellule à sélectionner,

  - en effacement: on soumet une connexion de source du transistor à grille flottante de cette première cellule, dit premier transistor, à une tension de masse (0V) du circuit intégré, on soumet une connexion de drain de ce premier transistor à une tension de masse, et on soumet une grille de commande de ce premier transistor à une haute tension de programmation plus élevée, par rapport à la tension de masse, qu'une tension d'alimentation du circuit intégré,
  - en programmation: on met la connexion de source de ce premier transistor en haute impédance, on soumet la connexion de drain de ce premier transistor à la haute tension de programmation ou à une haute impédance selon la nature d'un bit à écrire, et on soumet la grille de commande de ce premier transistor à une tension de masse,
  - en lecture: on soumet la connexion de source de ce premier transistor à la tension de masse, on connecte le drain de ce premier transistor à un amplificateur de lecture à seuil, et on soumet la grille de commande de ce premier transistor à une première tension de commande de lecture intermédiaire entre la tension de masse et la tension d'alimentation;

- pour une deuxième cellule à ne pas sélectionner

  - en programmation: on soumet la grille de commande du transistor à grille flottante de cette deuxième cellule, située dans une autre rangée que celle de la cellule sélectionnée, dit deuxième transistor, à une autre haute tension de programmation intermédiaire entre la première haute tension de programmation et la tension de masse,
  - en lecture: on soumet la connexion de source de ce deuxième transistor à la tension de masse, on soumet la connexion de drain de ce deuxième transistor à la tension de masse ou on la met en haute impédance, et on soumet la grille de commande de ce deuxième transistor à une deuxième tension de commande de lecture.

L'invention a également pour objet un procédé de gestion, dans un circuit intégré, de cellules mémoires électriquement effaçables et électriquement programmables, comportant chacune un transistor à grille flottante, caractérisé en ce qu'il comporte les opérations suivante pour programmer une cellule:

a) on efface la cellule, puis
b) on la programme avec un effet de programmation partiel en retirant des charges électriques de la grille flottante du transistor, puis on lit le contenu de la cellule;
c) on recommence les étapes de b) en augmentant l'effet de programmation, jusqu'à ce que le niveau de programmation soit jugé suffisant.

Elle a encore pour objet une mémoire dans un circuit intégré, comportant des cellules mémoires, accessibles par des lignes de bit et des lignes de mot, électriquement effaçables et programmables, chaque cellule comportant un transistor à grille flottante réalisé sous la forme de régions semi-conductrices enterrées dans un substrat, séparées par un canal de conduction, le substrat étant surmonté par des connexions de ligne de mot, une ligne de bit étant reliée à un circuit de lecture, caractérisée en ce que le drain de ce transistor à grille flottante est relié directement à la ligne de bit, en ce que la grille de commande de ce transistor à grille flottante est reliée directement à une ligne de mot, en ce que la source de ce transistor à grille flottante est reliée à une masse du circuit par l'intermédiaire d'un transistor interrupteur dont la grille de commande est reliée à la ligne de mot. De plus une connexion Pn permet d'acheminer sur la lignes Bn les tensions utiles en écriture. En pratique la connexion Pn se confond avec l'entrée de l'amplificateur ALn. Il en est de même des autres lignes de bit.

L'invention sera mieux comprise à la lecture de la description qui suit et à l'examen des figures qui l'accompagnent. Celles-ci ne sont données qu'à titre indicatif et nullement limitatif de l'invention. Les figures montrent:

- figures 1 et 2: déjà commentées, l'architecture et le mode de gestion des cellules mémoires d'une mémoire de l'état de la technique;
- figures 3 et 4: les mêmes éléments respectivement dans le cas de l'invention;
- figure 5: une variante préférée du procédé de gestion selon l'invention.

La figure 3 représente une structure en deux mots selon l'invention. Dans celle-ci des groupes de cellules, par exemple les groupes n et p sont rangés dans des colonnes. Dans chaque colonne il y a autant de lignes de bit BLn, BLn+1, BLn+2 ... qu'il y a de bits dans un mot contenu dans le groupe. Un premier mot ml est ainsi représenté dans le groupe de la colonne n. Chaque cellule d'un mot n'est constitué que par un transistor à grille flottante Mlec. Les drains D de ces transistors sont reliés directement aux lignes de bit BLn. La liaison est directe en ce sens que, la ligne de bit BLn étant une ligne qui passe au-dessus du plan mémoire, le drain D est relié par une connexion électrique passive, très conductrice à cette ligne de bit. A une extrémité la ligne de bit BLn est reliée à une entrée d'un amplificateur de lecture ALn à seuil. Cet amplificateur possède deux entrées et reçoit sur son autre entrée un seuil, une tension de seuil ou un courant de seuil, auquel est comparé dans l'amplificateur le phénomène qui se produit sur la ligne de bit BLn. Les transistors des cellules des mots d'une même colonne, qui ont un même rang dans ce mot, ont leur drain relié à une même ligne de bit. Les grilles de commande CG des transistors des cellules d'un mot sont reliées ensemble à une même ligne de mot r. Ces grilles sont aussi reliées en commun avec les grilles de commande des transistors des mots d'une même rangée. Les sources S de tous les transistors à grille flottante d'un mot sont reliées ensemble. Elles sont connectées à la masse, tension nulle, par un transistor MC ainsi que par un transistor MS en série. Le transistor MS est relié par drain et source d'une part aux sources S d'un mot et d'autre part à une connexion V. Le mot dans la rangée r+1 est relié de la même façon par un transistor MS+1. Il y a autant de transistors MS dans une rangée qu'il y a de mots dans cette rangée. Le transistor MS est commandé par le signal disponible sur la ligne de mot r qui est connectée sur sa grille de commande. Tous les transistors MS, MS+1 d'une même colonne ont tous leur source reliée à une ligne V, elle-même reliée à la masse par le transistor MC.

Un multiplexeur non représenté permet de ne connecter qu'un nombre limité de lignes de bit sélectionnés à des circuits de lecture, écriture et programmation. Les lignes de bit non sélectionnées sont alors soit connectées à une tension de masse, soit mises en haute impédance. La mise en haute impédance d'une ligne, dite aussi mise en l'air, revient à ouvrir la ligne (en pratique interposer un transistor bloqué) pour empêcher un courant de passer. Un courant nul ou infime est bien synonyme d'une haute impédance.

Il est possible de différencier le mode de connexion des grilles de commandes des transistors à grille flottante, par exemple en constituant des ensemble de mots. Dans un exemple, avec des mots de 8 bits, on peut faire des ensembles de 8 mots et donc différencier une rangée possédant 512 cellules en 8 ensembles différents. Dans ce cas, il y a 8 fois plus de lignes de mot r. On peut également dans de mêmes conditions séparer les connexions à la masse des sources des transistors à grille flottante et adopter la variante PEROM vue ci-dessus. Selon le nombre des circuits de lecture écriture programmable connectés au multiplexeur de ligne de bit, selon le nombre de rangées r, et les séparations d'interconnexion des sources, on pourra accéder à des mots ou des groupes de mots plus ou moins importants selon le type d'utilisation projeté pour la mémoire.

Dans tous les cas le procédé de l'invention s'y appliquera.

La différence par rapport à la structure décrite en figure 1 est la suivante:

- il n'y a plus de transistor de sélection Msel.
- la masse commutée GNDH est maintenant reliée à la masse par un transistor supplémentaire MS en série, dont la grille est reliée à la ligne de rangée;
- c'est le même signal qui joue à la fois le rôle de commande des grilles CG et de signal sur la ligne de rangée r. Il n'y a plus de connexion SC. Pour le reste les autres connexions et interruptions jouent un même rôle et ont une même configuration que dans la figure 1.

La figure 4 représente les conditions d'activation des différentes connexions, pour une page (une rangée entière dans un exemple), selon le procédé de la figure 3.

Les opérations d'écriture (effacement et programmation) se composent classiquement d'un cycle d'effacement global, suivi d'un cycle de programmation sélectif.

Lors d'un cycle d'effacement, seule la ligne r de la page sélectionnée reçoit la haute tension VPP (typiquement 15V). Les lignes r' des pages non accédées en effacement restent à une tension Vo faible devant la tension de programmation VPP. Typiquement Vo égale 0. De plus les lignes de bit, toutes ou au moins celles sélectionnées, sont portées à 0 Volt, alors que les sources des transistors sélectionnés sont portés à 0 Volts. En fait les lignes de bits sont portées à O Volt par le mécanisme suivant. La ligne r du mot à effacer est portée à 12 Volts. Les sources des cellules à effacer sont portées à la masse par l'intermédiaire des transistors MS et MC conducteurs. Donc les cellules sont passantes, donc leur ligne de bit se porte à la tension de masse par la conduction du transistor de la cellule elle-même. Dans ces conditions des électrons migrent du drain dans la grille flottante qui se charge de charges négatives dans le cas d'un substrat P.

Lors d'un cycle de programmation, les tensions appliquées sont celles de la figure 4. La ligne V est portée à une haute impédance puisque le transistor MC est bloqué par un signal nul sur sa grille SW. Les lignes de bit sélectionnées sont portées à VPP, ou flottante (soit haute impédance) selon la valeur du bit à programmer, et la ligne de mot sélectionnée r est portée à 0 Volt. Cette mise à haute impédance est obtenue en faisant déboucher la connexion Pn (ou l'entrée correspondante de l'amplificateur ALn) sur un circuit ouvert (par exemple par l'intermédiaire d'un transistor bloqué). Ceci porte les sources des transistors à grille flottante à une haute impédance par blocage du transistor MS. Néanmoins, un problème se pose. Du fait de l'absence de transistor de sélection, les drains des cellules d'une page non sélectionnée en programmation, r' différent de r, mais situés sur la même ligne de bit qu'une cellule en cours de programmation, vont recevoir la tension VPP de programmation. Ceci pourrait à priori occasionner une programmation parasite. La solution de l'invention consiste en ce que la tension Vo à laquelle sont portées les grilles de commande CG des transistors à grille flottante des pages non sélectionnées en programmation ait un niveau suffisant. De cette façon, la différence de potentiel entre la ligne de bit à VPP d'une cellule non sélectionnée en programmation et la grille de commande de cette cellule est bien inférieure à VPP. Les conditions d'effacement et d'écriture étant typiquement symétriques, on déduit que si Vo est dans ce cas de l'ordre de VPP/2, alors la tension aux bornes de l'oxyde tunnel d'une cellule non sélectionnée vaudra +/- VPP/2, selon qu'il s'agit de programmer un 1 ou un 0.

Il en résulte malgré tout qu'une cellule non sélectionnée subira une perturbation, puisque la tension aux bornes de son oxyde ne sera pas nulle. Cependant à cause du fait que le courant tunnel varie exponentiellement en fonction de la différence de potentiel appliquée à travers l'oxyde tunnel, le courant sera de plusieurs décades inférieur au courant de programmation "volontaire" d'une cellule normalement sélectionnée en programmation.

Par contre, on imagine qu'après un nombre suffisant de cycles de programmation, des cellules non sélectionnées pourront voir leur état s'inverser. L'invention s'adresse donc préférentiellement à des mémoires dont le contenu est modifié globalement ou dont le contenu peut être modifié partiellement mais un nombre limité de fois. En résumé quand on programme, pour les cellules à ne pas sélectionner, si elles sont situées dans la même rangée que les cellules sélectionnées, leurs lignes de bit sont connectées à une haute impédance (notamment par le multiplexeur de lignes de bit) et leur grille de commande sont portées à O Volt. Si elles sont situées dans une autre rangée, il convient de distinguer selon qu'elles sont ou non dans la même colonne que les cellules sélectionnées. Si elles sont dans la même colonne, leur ligne de bit sont portées à VPP et leur grille de commande à VPP/2. Si elles sont dans une autre colonne, leurs ligne de bit sont à la haute impédance et leurs grille de commande sont portées à VPP/2. Dans les deux cas il y a au maximum une tension VPP/2 insuffisante pour programmer.

En lecture, les transistors MC et MS sont rendus passants par des signaux SW et r portés à une tension suffisante. Par exemple on peut porter la ligne r à une tension CGref égale à VCC (5 Volts), la tension d'alimentation du circuit intégré.

Une autre difficulté se pose là encore du fait de la suppression du transistor de sélection. En effet, dans l'approche classique, une seule cellule est connectée à une ligne de bit sélectionnée. De cette façon, le courant entre la ligne de bit et la masse correspond exactement au courant passant dans cette unique cellule sélectionnée. Dans le cas de l'invention plusieurs cellules peuvent être sollicitées.

La solution est apportée par la mise à un potentiel négatif des grilles de commande des cellules connectée à la même ligne de bit mais appartenant à une autre rangée que la rangée de la cellule sélectionnée en lecture. Ce potentiel négatif, dans un exemple -2V, permet de bloquer une cellule qui appartiendrait à une autre ligne de mot (ou une autre page) et qui serait programmée. Le potentiel négatif appliqué à la grille de commande du transistor à grille flottante de cette cellule compense alors le potentiel positif auquel est chargée cette grille flottante. De sorte que la tension grille flottante-substrat d'une cellule programmée non sélectionnée est maintenant, au plus, inférieure ou égale à la tension de seuil du transistor de la cellule. Ce transistor n'est plus passant.

Par exemple, si Vt est la tension de seuil du transistor de la cellule, si Vp est la tension positive de charge de la grille flottante de la cellule programmée, et si VN est la tension négative appliquée à la grille de commande de la cellule non sélectionnée, le transistor sera bloqué si VN + Vp est inférieur à Vt soit VN inférieur à Vt-Vp. Typiquement, Vt = 0,5V et Vp = 2V. On bloquera donc une cellule programmée en lui appliquant sur la grille de commande une tension négative de valeur absolue supérieure à 1 V. Par exemple -2V. Cette tension est produite par une pompe de charge négative. De telles pompes sont connues et notamment décrites dans la demande de brevet Français n°FR-A-2 735 927.

A fortiori, une cellule effacée à laquelle on applique une telle tension de commande négative est bloquée, puisque la charge initiale sur sa grille flottante est déjà négative. Si Vn est la tension négative de charge de la grille flottante d'une cellule effacée, la tension au niveau de la grille flottante vaudra: V(FG) = VN + Vn. Pour une valeur typique de Vn de -2V, et dans les conditions précédentes, on aura:

$$V(FG) = -2-2 = -4V;$$

Cependant la tension d'une ligne de bit en lecture peut classiquement atteindre 2 Volts au moment de la précharge de la ligne de bit. Dans ce cas, une cellule non sélectionnée effacée, appartenant à cette ligne de bit verra une différence de potentiel drain - grille de commande de 2 - (-4) = 6V.

Une telle tension peut alors provoquer un courant tunnel infime, parasite, tendant à commencer à reprogrammer, au maximum à rendre vierge, une cellule placée dans ces conditions. Une cellule vierge est une cellule dans laquelle il n'y a pas du tout de charge sur la grille flottante. Le phénomène de programmation parasite ne peut tendre alors qu'à rendre vierge une cellule car, dès qu'il n'y a plus de charges stockées, le phénomène de programmation parasite s'arrête. Ce courant de programmation parasite est infime car l'effet tunnel varie de façon exponentielle avec la tension appliquée à l'oxyde tunnel.

Les tensions nécessaires pour programmer ou effacer correctement une cellule étant supérieures à 12 V, typiquement, une tension de 5V créera une perturbation infime. Cependant on peut imaginer qu'au bout de plusieurs années de lecture continue, une cellule initialement bien effacée deviendra vierge (charge nulle). On risquerait donc de ne plus pouvoir lire cette cellule. La parade, selon l'invention, consiste, dans un perfectionnement, à décaler la tension de lecture, de sorte qu'une cellule vierge soit en fait lue comme effacée. Un décalage très léger suffit, de sorte qu'une cellule mal programmée soit quand même lue passante.

Par exemple une cellule programmée (à +2V sur sa grille flottante dans la première solution de l'invention qui correspond à une lecture aux tensions négatives) doit laisser passer du courant au moment de la lecture. Ce courant provoque la chute de la tension de la ligne de bit préchargée. La tension de cette ligne de bit comparée à une tension de référence, de par exemple 1 Volt, provoque le basculement de l'amplificateur différentiel (de seuil) tLi. Comme une cellule volontairement insuffisamment programmée (qui a reçu une charge proche de l'état vierge, dans le cas de la variante) va laisser passer moins de courant, la tension de la ligne de bit va chuter moins fort. Dans ces conditions, il suffit d'augmenter la valeur de la tension de comparaison. Celle-ci passera par exemple de 1 Volt (pour la lecture d'une vraie cellule vierge) à 1,2 Volt (pour la lecture d'une cellule volontairement insuffisamment programmée). Dans ce cas on est de nouveau capable de lire au bon moment.

Dans la réalisation de l'invention, le blocage des cellules non sélectionnées d'une ligne de bit en lecture nécessite d'appliquer une tension de grille de commande CG négative, ce qui peut avoir deux inconvénients déjà cités:

- La nécessité d'utiliser une pompe de charge négative en lecture, ce qui rend plus complexe le circuit de décodage de rangées, prend de la place, et entraîne une certaine consommation en lecture due au fonctionnement de cette pompe;
- La perturbation en lecture, qui tend à rendre vierge une cellule effacée.

Une variante de l'invention consiste alors à sous-programmer les cellules devant être programmées. Dans le cas de la première description de l'invention, une cellule programmée possède une charge positive suffisamment importante sur sa grille flottante, de sorte que même si sa grille de commande est portée à 0V, le transistor de lecture Mlec est passant. On peut, selon la variante, rendre les cellules programmées seulement proches de l'état vierge, par exemple sans charge sur la grille flottante, voire même un peu effacées (charge négative plus faible sur la grille flottante que pour une cellule bien effacée). Ces cellules programmées ne sont alors plus à l'état passant lorsque leur grille de commande CG est portée à 0V. Dans ce cas, il n'est plus indispensable d'appliquer une tension négative sur la grille de commande d'une cellule programmée pour la bloquer.

Pour lire une cellule, il faut alors tester si elle est bien effacée, ou peu effacée voire proche de vierge. La deuxième situation conduit à la considérer comme programmée. Ceci peut se faire avec les circuits de lecture classiques, en décalant simplement le niveau de lecture comme indiqué ci-dessus. Une difficulté apparaît cependant. Faire passer une cellule à un état proche de l'état vierge n'est pas facile. Classiquement, il n'y a aucun contrôle de la charge de la grille flottante en cours de programmation ou au cours de l'effacement. Le but est classiquement que cette charge, à la fin du cycle, soit la plus élevée possible, tant positivement que négativement. Avec la variante de l'invention il est prévu de contrôler la charge envoyée dans une cellule au cours du cycle de programmation. On sait qu'au départ du cycle de programmation, la cellule est dans l'état parfaitement effacé puisqu'on a procédé préalablement à un effacement. Une solution consiste alors à effectuer des cycles programmation-lecture successifs, en incrémentant à chaque fois le niveau de programmation. Ce niveau peut être augmentée en augmentant VPP d'un cycle à l'autre, ou en augmentant, à VPP donné, un nombre d'impulsions brèves de programmation mises en oeuvre. A chaque lecture, on teste l'état de la cellule. Si la cellule est lue comme programmée, on stoppe la programmation, ou éventuellement on effectue un cycle supplémentaire de programmation. Le circuit de lecture, lors de cette phase de programmation par paliers, peut être aussi légèrement décalée par rapport à la lecture en temps normal, de façon à garantir une certaine marge sur la lecture d'une cellule programmée. Ce décalage doit consister à lire comme bloquée une cellule mal rendue vierge, c'est à dire encore trop dans l'état effacé. Eventuellement, avant chaque cycle, on efface à nouveau la cellule. Le cycle comporte alors les opérations effacement-programmation-lecture, la programmation augmentant d'un cycle à l'autre.

Ces techniques de programmation progressive sont du même type que celles utilisées dans le stockage multi-niveaux de charge dans les cellules de type FLASH ou EEPROM.

La figure 5 représente le nouveau schéma d'activation de la cellule, selon cette variante de l'invention. On y note deux différences par rapport à la figure 4. Il n'y a plus de tension négative. Les tensions lors de la programmation sont appliquées par des cycles entiers programmation lecture. Au besoin chacun de ces cycles peut comporter une phase d'effacement préalable pour bien maîtriser l'état de départ.

On a aussi réussi à créer une structure EEPROM, ou PEROM, bien plus compacte que la structure classique, grâce à la suppression du transistor de sélection, en combinant en un seul signal les signaux de sélection de rangée, et de grille de commande. Le gain en encombrement est de l'ordre de 40%. En utilisant de plus une approche de type PEROM, le gain en surface par rapport à une mémoire EEPROM classique avoisine les 50%.

**Revendications**

1. Procédé de gestion, dans un circuit intégré, de cellules mémoires électriquement effaçables et électriquement programmables, comportant chacune un transistor à grille flottante, caractérisé en ce qu'il comporte les opérations suivantes:

   - pour une première cellule à sélectionner

      - en effacement: on soumet une connexion de source du transistor à grille flottante de cette première cellule, dit premier transistor, à une tension de masse (0V) du circuit intégré, on soumet une connexion de drain de ce premier transistor à une tension de masse, et on soumet une grille de commande de ce premier transistor à une haute tension de programmation (VPP) plus élevée, par rapport à la tension de masse, qu'une tension d'alimentation (VCC) du circuit intégré,
      - en programmation:

         a) on efface la première cellule,
         b) on met la connexion de source de ce premier transistor en haute impédance,
         c) on la programme avec un effet de programmation partiel en retirant des charges électriques de la grille flottante du premier transistor, puis on lit le contenu de la première cellule,
         d) on recommence les étapes de c) en augmentant l'effet de programmation, jusqu'à ce que le niveau de programmation soit jugé suffisant.

      - en lecture: on soumet la connexion de source de ce premier transistor à la tension de masse, on connecte le drain de ce premier transistor à un amplificateur de lecture à seuil, et on soumet la grille de commande de ce premier transistor à une première tension de commande de lecture intermédiaire entre la tension de masse et la tension d'alimentation;

   - pour une deuxième cellule à ne pas sélectionner

      - en programmation: on soumet la grille de commande du transistor à grille flottante, dit deuxième transistor, de cette deuxième cellule située dans une autre rangée que celle de la cellule sélectionnée, à une autre haute tension de programmation (VPP/2) intermédiaire entre la première haute tension de programmation et la tension de masse,

   - en lecture: on soumet la connexion de source de ce deuxième transistor à la tension de masse, on soumet la connexion de drain de ce deuxième transistor à la tension de masse ou on la met en haute impédance, et on soumet la grille de commande de ce deuxième transistor à une deuxième tension de commande de lecture.

2. Procédé selon la revendication 1, caractérisé en ce qu'on soumet la grille de commande de ce deuxième transistor à une deuxième tension de commande de lecture négative par rapport à la tension de masse.

3. Procédé selon l'une des revendications 1 ou 2, caractérisé en ce que

   - on lit le contenu de la cellule avec une tension de référence de lecture décalée par rapport à une première tension de lecture.

4. Mémoire dans un circuit intégré, comportant des cellules mémoires, accessibles par des lignes de bit et des lignes de mot, électriquement effaçables et programmables, chaque cellule comportant un transistor à grille flottante réalisé sous la forme de régions semi-conductrices enterrées dans un substrat, séparées par un canal de conduction, le substrat étant surmonté par des connexions de ligne de mot, une ligne de bit étant reliée à un circuit de lecture, caractérisée en ce que le drain de ce transistor à grille flottante est relié directement à la ligne de bit, en ce que la grille de commande de ce transistor à grille flottante est reliée directement à une ligne de mot, en ce que la source de ce transistor à grille flottante est reliée à une masse du circuit par l'intermédiaire d'un transistor interrupteur dont la grille de commande est reliée à la ligne de mot.

5. Mémoire selon la revendication 4 caractérisée en ce qu'elle comporte une source de tension négative pour être appliquée sur des lignes de mots correspondant à des cellules non sélectionnées.

## FIG_1

### ETAT DE LA TECHNIQUE

EP 0 845 785 A1

FIG_3

EP 0 845 785 A1

| OPERATIONS \ NŒUDS | SW | SC | BL | SR | SR'≠SR |
|---|---|---|---|---|---|
| EFFACEMENT | Vcc | Vpp | 0 | Vpp | 0 |
| PROGRAMMATION | 0 | 0 | Vpp | Vpp | 0 |
| LECTURE | Vcc | CGREF | TENSION LUE | Vcc | 0 |

$\underline{FIG\_2}$

| OPERATIONS \ NŒUDS | SW | BL | r | r'≠r |
|---|---|---|---|---|
| EFFACEMENT | Vcc | 0 | Vpp | 0 |
| PROGRAMMATION | 0 | Vpp / Flottant | 0 | Vpp/2 |
| LECTURE | Vcc | TENSION LUE | CGREF | -2 VN |

$\underline{FIG\_4}$

| OPERATIONS \ NŒUDS | SW | BL | r | r'≠r |
|---|---|---|---|---|
| EFFACEMENT | Vcc | 0 | Vpp | 0 |
| PROGRAMMATION | 0 | Vpp / Flottant | 0 | Vpp/2 |
| LECTURE | Vcc | TENSION LUE | CGREF | 0 |

$\underline{FIG\_5}$

EP 0 845 785 A1

**Office européen des brevets**

**RAPPORT DE RECHERCHE EUROPEENNE**

Numéro de la demande

EP 97 40 2870

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 182 198 A (EXEL MICROELECTRONICS INC) 28 mai 1986 | 4 | G11C16/04 G11C16/06 |
| Y | * page 21, ligne 28 - page 22, ligne 16; figure 5D * | 5 | |
| Y | KANAMORI K ET AL: "A HIGH CAPACITIVE COUPLING RATIO (HICR) CELL FOR SINGLE 3 V POWER SUPPLY FLASH MEMORIES" NEC RESEARCH AND DEVELOPMENT, vol. 36, no. 1, janvier 1995, pages 122-131, XP000532542 * page 123, colonne de droite, ligne 30 - page 124, colonne de gauche, ligne 15; figure 7 * | 1-3 | |
| Y | EP 0 701 259 A (SAMSUNG ELECTRONICS CO LTD) 13 mars 1996 * page 6, ligne 31 - page 7, ligne 19; figure 7 * | 1-3 | |
| Y | WO 92 10837 A (NEXCOM TECHNOLOGY INC) 25 juin 1992 | 5 | DOMAINES TECHNIQUES RECHERCHES (Int.Cl.6) |
| A | * page 8, ligne 13 - ligne 23; figure 4; tableau I * | 1,2 | G11C |
| A | EP 0 606 769 A (FUJITSU LTD) 20 juillet 1994 * colonne 7, ligne 39 - colonne 8, ligne 1; revendication 1; figure 6 * | 3 | |
| A | US 5 467 307 A (D ARRIGO IANO ET AL) 14 novembre 1995 * colonne 4, ligne 5 - colonne 5, ligne 63; figure 2; tableau 1 * | 1,2,5 | |

-/--

Le présent rapport a été établi pour toutes les revendications

| Lieu de la recherche | Date d'achèvement de la recherche | Examinateur |
|---|---|---|
| LA HAYE | 4 mars 1998 | Cummings, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

**Office européen des brevets**

# RAPPORT DE RECHERCHE EUROPEENNE

Numéro de la demande

EP 97 40 2870

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | GB 2 215 155 A (INTEL CORP) 13 septembre 1989<br>* page 16, ligne 16 - page 18, ligne 21; figures 6,7 *<br>--- | 1 | |
| A | US 5 283 758 A (NAKAYAMA TAKESHI ET AL) 1 février 1994<br>* colonne 1, ligne 31 - colonne 3, ligne 37; figure 1A; tableau *<br>----- | 1 | |

**DOMAINES TECHNIQUES RECHERCHES (Int.Cl.6)**

Le présent rapport a été établi pour toutes les revendications

| Lieu de la recherche | Date d'achèvement de la recherche | Examinateur |
|---|---|---|
| LA HAYE | 4 mars 1998 | Cummings, A |